Europäisches Patentamt

European Patent Office

Office européen des brevets

(11) Veröffentlichungsnummer: **0 489 343 A2**

# EUROPÄISCHE PATENTANMELDUNG

(21) Anmeldenummer: **91120215.8**

(22) Anmeldetag: **26.11.91**

(51) Int. Cl.5: **H05K 7/20**, H05K 3/12,
H05K 5/00

(30) Priorität: **05.12.90 DE 4038786**

(43) Veröffentlichungstag der Anmeldung:
**10.06.92 Patentblatt 92/24**

(84) Benannte Vertragsstaaten:
**AT BE CH DE DK ES FR GB GR IT LI LU NL SE**

(71) Anmelder: **BSG-Schalttechnik GmbH & Co. KG**
**Meisterstrasse 19**
**W-7460 Balingen 1(DE)**

(72) Erfinder: **Prestel, Fritz**
**Giessstrasse 93**
**W-7461 Hausen a. Tann(DE)**

(74) Vertreter: **Otte, Peter, Dipl.-Ing.**
**Tiroler Strasse 15**
**W-7250 Leonberg(DE)**

(54) **Vorrichtung zur Steuerung oder Regelung von durch Akkus versorgter Geräte.**

(57) Bei einer zur Steuerung oder Regelung des Betriebs von durch Akkus oder Batterien versorgter Geräte, insbesondere zur Stromsteuerung von Elektro(hand)geräten wie Akkuschrauber, Akkubohrer u. dgl., mit einem Gehäuse, einem äußeren, verschiebbaren Drückergriff am Gehäuse und einer elektrischen, durch die Drückergriffverschiebung in ihrer Funktion vorzugsweise infolge Potentiometerverstellung gesteuerten Schaltung mit mindestens einem Leistungshalbleiter wird vorgeschlagen, den Leistungshalbleiter über den der Stromfluß zum Gerätemotor gesteuert ist, auf einer gehäuseinternen Schaltungsplatte anzuordnen, die ihrerseits einen Kühlkörper großflächig kontaktiert, der durch eine Gehäusedurchbrechung frei nach außen ragt.

Fig.4

EP 0 489 343 A2

Stand der Technik

Die Erfindung geht aus von einer Vorrichtung nach dem Oberbegriff des Anspruchs 1.

Vorrichtungen bzw. Elektronikschalter, die der Steuerung von durch Akkus oder Batterien versorgten elektrischen Geräten dienen, speziell der Anschaltung von Elektromotoren an sie mit Strom versorgenden Akkumulatoren, sind in einer Vielzahl von Ausführungsformen bekannt, und zwar speziell in Verbindung mit Elektrohandgeräten wie Bohrmaschinen, Akkuschrauber o. dgl., bei denen im Steuerungsfall der von einem Akku dem antreibenden Motor des Elektrohandgeräts zugeführte Strom über einen Leistungshalbleiter fließt, der in seiner Leitfähigkeit letztendlich von der Position eines Drückerhandgriffs so beeinflußt ist, daß eine Leistungssteuerung des Betriebs des Elektromotors möglich ist.

Entsprechende Akkuschalter, wie sie beispielsweise von Firmen wie CAPAX u. dgl. hergestellt und vertrieben werden, sind üblicherweise so ausgebildet, daß mindestens der Leistungstransistor als Einzelbaustein zusammen mit einem erforderlichen Kühlkörper extern zum Elektronikschaltergehäuse angeordnet werden muß, an einer Stelle innerhalb des Geräts, dessen Motor gesteuert oder geregelt werden soll. Auf diese Weise kann man den Leistungshalbleiter so hinreichend kühlen, beispielsweise durch Befestigen an einer Gehäusewandung o. dgl., daß Beschädigungen beim gesteuerten Betrieb weitgehend ausgeschlossen sind.

Dabei ist der bekannte Aufbau beispielsweise des CAPAX-Elektronikschalters ferner so getroffen, daß ein eigentliches, geschlossenes Gehäuse nicht vorgesehen ist; es wird ein aus drei deutlich unterscheidbaren Gehäuseteilkomponenten durch Zusammenstecken gebildetes Gehäuse realisiert, zusätzlich zu dem Einzelbaustein des Leistungstransistors. So befindet sich auf dem bekannten Gehäuse aufgerastet ein separater Rechts/Links-Umschalter, der selbst über zwei außen längs des Gehäuses geführte Leitungsanschlüsse mit dem Gehäuse verbunden ist, und zwar zusätzlich zu drei weiteren Zuleitungen, die von dem Gehäuse zum Einzelbaustein des Leistungstransistors geführt werden müssen.

Sämtliche insofern internen oder auch nach außen weiterführenden elektrischen Anschlüsse, also zum Akku bzw. zu den Motoranschlüssen sind als Direktanschlüsse gebildet, die es erforderlich machen, verzinnte Drahtenden in Gehäuseöffnungen einzuführen, in denen sie dann durch Sperrzungen arretiert werden.

Dies ist aufwendig, nicht unbedingt zuverlässig, da sich solche Steckanschlüsse durchaus wieder lösen können, umständlich und im übrigen auch nichtstaubsicher, da jedenfalls durch die Einführungsöffnungen für die Anschlußdrähte auch Verschmutzungen in das Gehäuseinnere eintreten können, welches aber darüber hinaus ohnehin nicht besonders staubsicher ausgelegt ist.

Die Montage solcher bekannter Akku-Steuerungsschalter auf elektronischer Grundlage ist daher ebenfalls kompliziert, aufwendig und, allein schon wegen der Vielzahl äußerer elektrischer Verbindungsleitungen auch nicht immer hinreichend narrensicher ausgeführt, so daß Fehler bei ungeübtem Personal auftreten können. Ferner ergeben sich innerhalb des mit einem solchen Elektronikschalter versorgten Geräts eine Vielzahl von elektrischen Leitungsverbindungen, die außerhalb der angenähert kastenförmigen Gehäuseform des Elektronikschalters verlaufen und daher ebenfalls Störungen unterworfen sein können.

Die Erfindung stellt allgemein auf einen solchen Elektronikschalter zur Steuerung von Motoren beispielsweise bei Elektrohandgeräten ab, die aus Akkus oder Batterien versorgt werden. Es versteht sich aber, daß dies lediglich ein bevorzugtes Ausführungsbeispiel der Erfindung ist und ein Einsatz auch bei anderen batteriebetriebenen Einrichtungen und Systemen möglich ist. Die Beschreibung der Erfindung sowie auch im vorhergehenden des bekannten Stands der Technik betrifft lediglich ein spezielles Anwendungsgebiet, auf welchem der Gegenstand der Erfindung auch mit besonderem Vorteil einsetzbar ist.

Der Erfindung liegt die Aufgabe zugrunde, bei einer Versorgungsschaltung für durch Akku- oder Batteriebetrieb versorgte Verbraucher, speziell Motorantriebe, den die Last, also den Motor steuernden Leistungshalbleiter einerseits innerhalb eines geschlossenen, eng begrenzten Schaltergehäuses aufzunehmen und andererseits dafür zu sorgen, daß dennoch eine hinreichende Wärmeabfuhr gesichert ist.

Vorteile der Erfindung

Die erfindungsgemäße Vorrichtung löst diese Aufgabe mit den kennzeichnenden Merkmalen des Hauptanspruchs und hat den Vorteil, daß es möglich ist, auf einer Schaltungs- oder Printplatte, die vorzugsweise von einem Keramiksubstrat gebildet ist, auch den üblicherweise eine vergleichsweise hohe Verlustleistung aufweisenden Leistungshalbleiter anzuordnen, ohne daß es zu lokalen oder allgemeinen Überhitzungserscheinungen und unter Umständen auch zur Zerstörung mindestens des Leistungshalbleiters kommt.

Durch die innige großflächige Verbindung des Keramiksubstrats, wie die Schaltungsplatte im folgenden speziell, ohne den erfindungsgemäßen Rahmen jedoch einzuschränken, genannt werden soll, mit einem in etwa gleich großen Kühlkörper wird zunächst ein entsprechend freier und ungehinderter Wärmeübertritt vom Keramiksubstrat auf den Kühlkörper ermöglicht, der dann seinerseits als weiterer Schritt durch eine ihm angepaßte Gehäusedurchbrechung aus dem die gesamte elektrische Schaltung aufnehmenden Gehäuse nach außen ragt.

Hierdurch ergibt sich entweder durch die an dieser Stelle ohnehin vorhandene freie Luftzirkulation schon eine hinreichende Kühlung des Ganzen oder es ist möglich, den Kühlkörper dann seinerseits wieder in wärmeleitenden Kontakt mit anderen Elementen, Platten, Gehäuseinnenseiten o. dgl. zu bringen, die beispielsweise bei dem von der elektrischen Schaltung der erfindungsgemäßen Vorrichtung angetriebenen Gerät bzw. innerhalb dessen Gerätegehäuses vorhanden sind.

Es ist vorteilhaft, den Kühlkörper auf der Rückseite des Keramiksubstrats mit einem wärmeleitfähigen Kleber aufzukleben; man kühlt hierdurch nicht nur lokal den bereich des IC auf dem Keramiksubstrat, der den Leistungshalbleiter üblicherweise in Form eines entsprechend kraftvoll ausgelegten MOS-FET's enthält, sondern auch die sonstigen Schaltungselemente, die sich auf dem Keramiksubstrat befinden, beispielsweise Löschdiode u. dgl.

Versuche haben ergeben, daß durch eine solche Gestaltung der Steuerungsvorrichtung und Einbau in ein einheitliches, geschlossenes Gehäuse mit sämtlichen sonst noch beteiligten Schaltungskomponenten eine Überhitzung auch in extremen Steuerungsfällen nicht zu befürchten ist, wobei in einer vorteilhaften Ausgestaltung ferner die "Intelligenz" des den MOS-FET enthaltenden IC's so ausgelegt ist, daß bei Annäherung und gegebenenfalls Überschreiten eines Grenztemperaturbereichs, der beispielsweise zwischen 140 - 170 °C liegt, der IC selbst im Sinne einer Temperaturregelung den von ihm an den Verbraucher, üblicherweise einen Elektromotor gelieferten Laststrom zurücknimmt. Durch diese Temperaturregelung wird die gesamte Elektronik vor Übertemperatur geschützt, wobei die Stromregelung einschließlich Temperaturbegrenzung bevorzugt so realisiert wird, daß nach dem Verfahren der Puls-Weiten-Modulation der Strom durch Verbreiterung bzw. Verschmälerung von Stromimpulsen konstanter Höhe und Frequenz erhöht bzw. erniedrigt wird. Der IC nimmt dann bei Einsetzen seiner internen Temperaturregelung lediglich die Pulsweite so weit zurück, wie dies für sein wärmetechnisches Wohlergehen erforderlich ist.

Vorteilhaft ist, daß eine solche, vom Willen der Bedienungsperson des Geräts, beispielsweise eines Bohrers oder Schraubers unabhängige Leistungsrücknahme von der Bedienungsperson praktisch deshalb kaum bemerkt wird, sofern eine solche Temperaturregelung überhaupt einsetzt, weil im angenommenen Fall die Bedienungsperson notwendigerweise schon an der oberen Grenze des gesteuerten Betriebs mit dem Gerät gearbeitet haben muß, denn sonst würde die Temperaturregelung nicht einsetzen. In einem solchen Fall wird die Bedienungsperson, wenn dieser kaum merkliche Einfluß der Temperaturregelung unerwünscht ist, einfach den Drückergriff stärker nachdrücken, woraufhin die gesamte Steuervorrichtung in die elektrische By-Pass-Position gelangt, in welcher die Elektronik von einem Schalter überbrückt und die Akku-Ausgangsanschlüsse unmittelbar mit den Motoreingangsanschlüssen verbunden werden. In diesem Fall liegt dann am Motor die volle Leistung bei gleichzeitig gebotener größtmöglicher Kühlmöglichkeit für die nicht mehr beanspruchte Elektronik.

Durch die in den Unteransprüchen aufgeführten Maßnahmen sind vorteilhafte Weiterbildungen und Verbesserungen der im Hauptanspruch angegebenen Vorrichtung möglich. Besonders vorteilhaft ist auch die direkte Verbindung der von der Schaltungsplatte als Keramiksubstrat senkrecht wegstehenden zweiten Schenkel der Kontaktwinkel mit internen Kontaktbahnen in Form von stegartigem metallischem Bandmaterial, die im Gehäuse verlaufen und hierdurch auch für eine relative Positionierung der einzelnen Schaltungskomponenten im Gehäuse sorgen.

Zeichnung

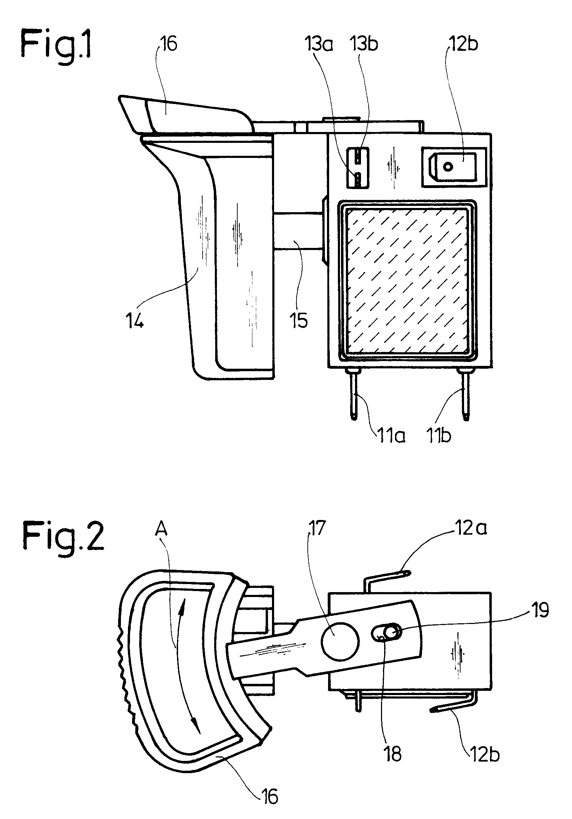

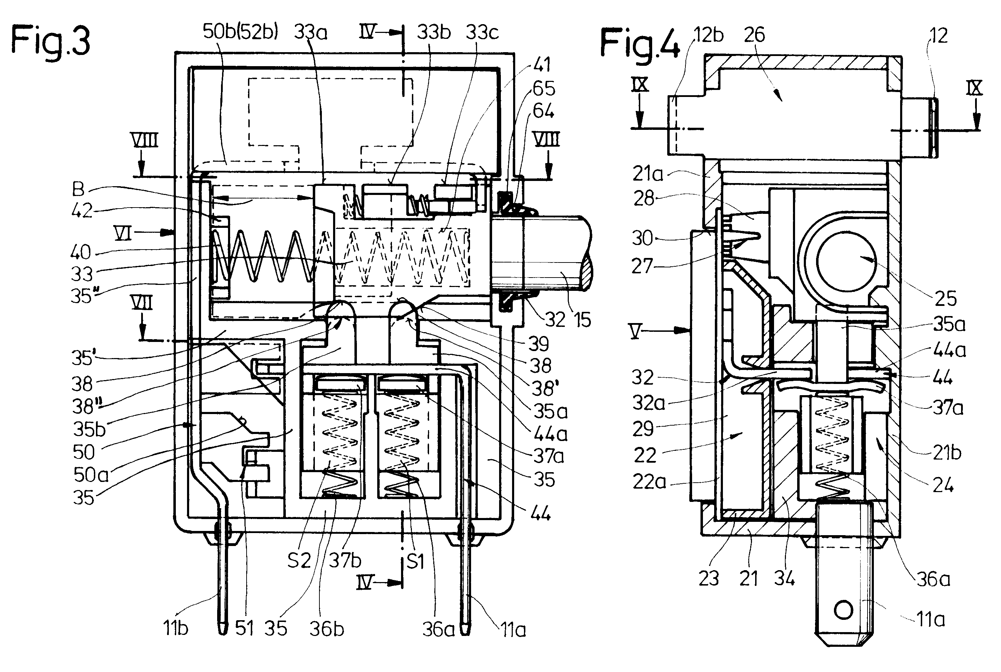

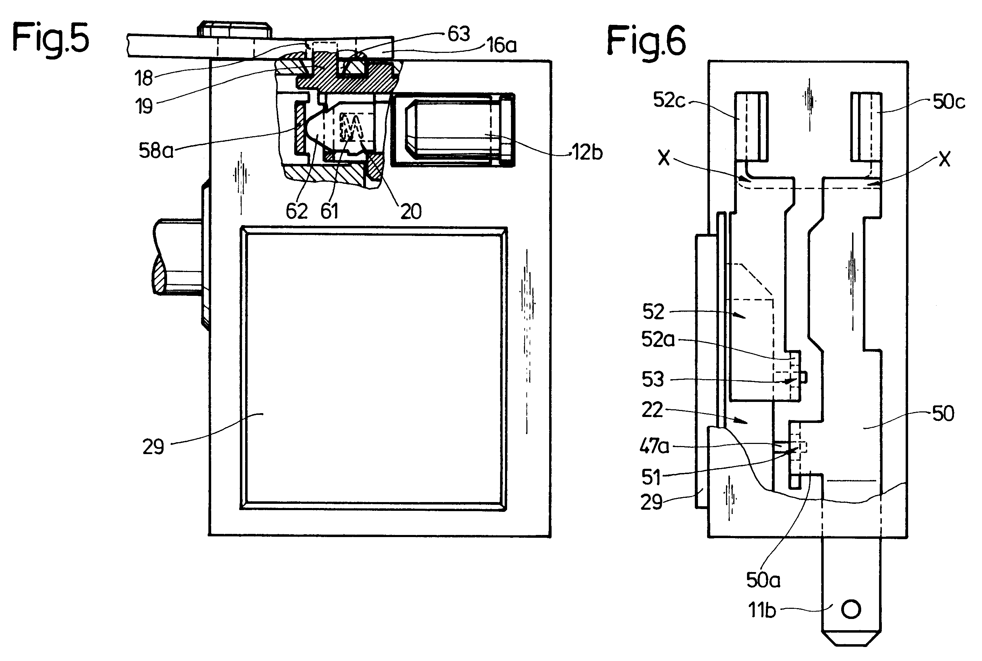

Ausführungsbeispiele der Erfindung sind in der Zeichnung dargestellt und werden in der nachfolgenden Beschreibung näher erläutert. Es zeigen:
Fig. 1
in einer Seitenansicht eine Ausführungsform eines erfindungsgemäßen Elektronikschalters (Start- und Gasgebe-Schalter) für Akkugeräte mit sämtlichen Arbeitskomponenten in einem gemeinsamen Gehäuse (Ein-Gehäuse-Prinzip);
Fig. 2
eine Ansicht des Elektronikschalters der Fig. 1 von oben;
Fig. 3
in größerem Detail den erfindungsgemäßen Elektronikschalter von einer der Seitenansicht der Fig. 1 gegenüberliegenden Seite bei abgenommenem Gehäusedeckel;
Fig. 4
einen Schnitt längs der Linie IV-IV der Fig. 3, wobei Einzelheiten oberhalb und im Bereich der Drückerführung zum besseren Verständnis weggelassen sind;
Fig. 5
eine Seitenansicht aus der Richtung V der Fig. 4 mit Teilschnittdarstellung im Bereich der oberen Links-Rechts-Umschaltung;

Fig. 6

schematisiert eine Seitenansicht von der linken Seite der Fig. 3 entsprechend dem Pfeil VI, mit weggeschnittenen Wandteilen zur Darstellung des Verlaufs von Kontaktbahnführungen in diesem Bereich längs der schmalen Querseite des Elektronikschaltergehäuses;

Fig. 7

einen Schnitt längs der Linie VII, stark vereinfacht und unter Weglassung weiterer Einzelteile, aus dem sich die Befestigung von Kontaktbahnwinkeln eines elektronischen Hybridschaltungsaufbaus an den Kontaktbahnführungen erkennen läßt;

Fig. 8

einen Schnitt längs der Linie VIII-VIII der Fig. 3, ebenfalls unter Weglassung von Teilen zur Verdeutlichung einer Schaltstückführung im Bereich des Drückers sowie des Potentiometerschleifers auf dem Hybrid-Baustein;

Fig. 9

zeigt einen Schnitt längs der Linie IX-IX der Fig. 4, aus dem die Einzelheiten der in das Elektronikschaltergehäuse integrierten Rechts-Links-Umschaltung erkennbar werden;

Fig. 10

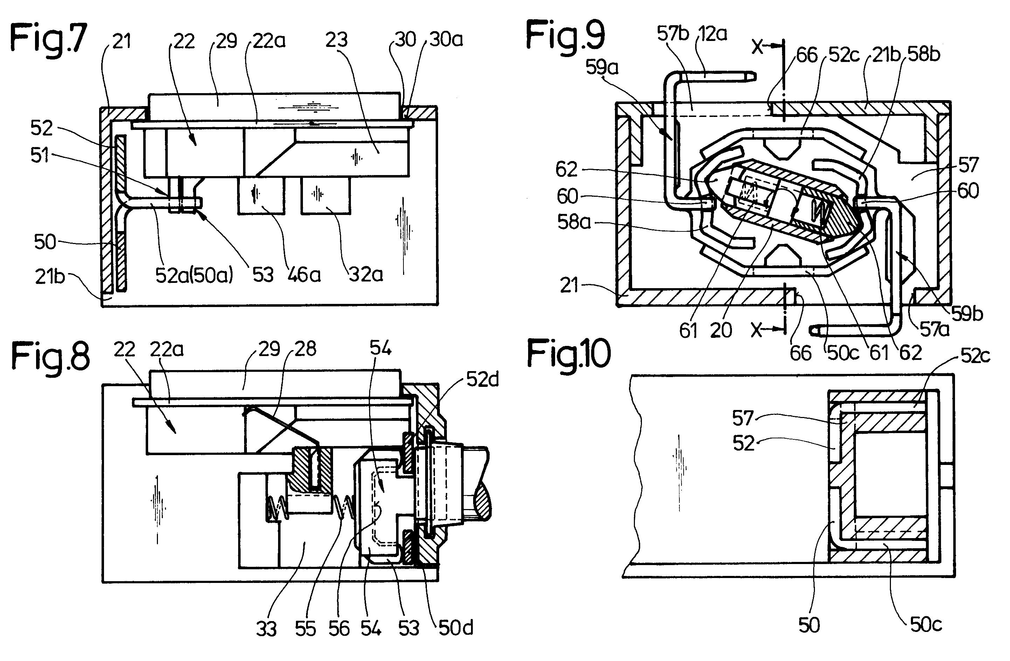

zeigt als Teilschnitt, wieder mit weggelassenen Teilen ein separates Einsatzgehäuse für die Rechts-Links-Umschaltung, grundsätzlich längs der Linie X-X der Fig. 9, jedoch bei weggelassener innerer Umschaltwippe;

Fig. 11

zeigt in einer Seitenansicht eine erste, durchgehende, innerhalb des Elektronikschaltergehäuses verlegte Kontaktbahnführung mit gleichzeitiger Kontaktierung nach außen, am Hybridbaustein, im Bereich des Rechts-Links-Umschalters und einer Motor-Kurzschlußschaltung;

Fig. 12

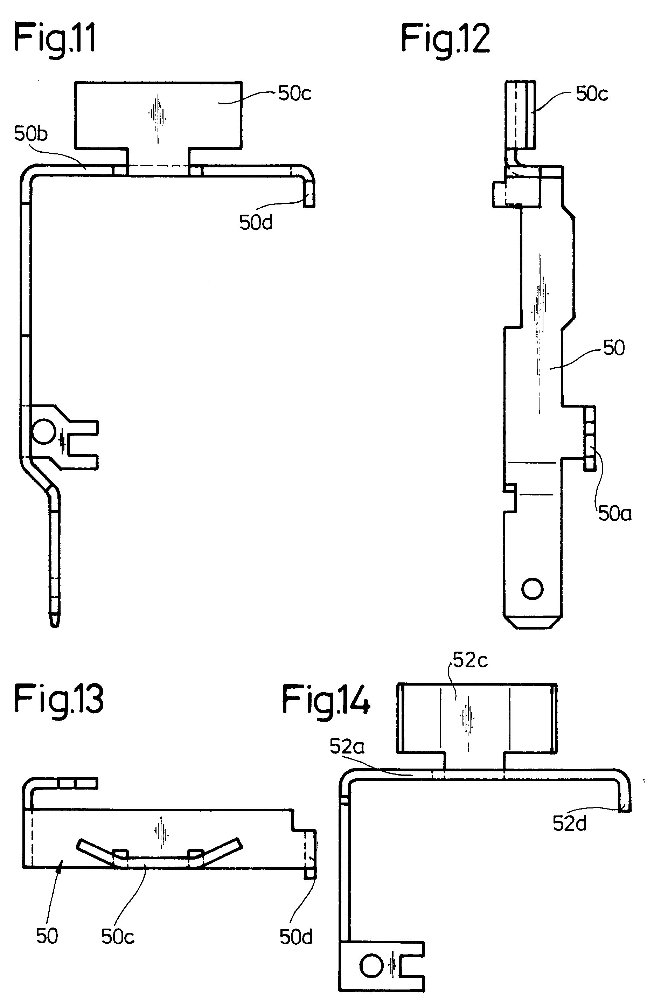

zeigt die Kontaktbahnführung der Fig. 11 in einer Seitenansicht;

Fig. 13

zeigt die Kontaktbahnführung der Fig. 11 und 12 in einer Ansicht von oben;

Fig. 14

zeigt eine zweite, innerhalb des Elektronikschaltergehäuses verlegte verkürzte Kontaktbahnführung, die vom Anschluß des Hybridbausteins bis zur Rechts-Links-Umschaltung und zur Motorkurzschlußkontaktierung führt;

Fig. 15a, 15b, 15c

zeigen in Draufsicht und zwei Seitenansichten eine mögliche Ausführungsform der Anordnung von Schaltungskomponenten sowie Kontaktwinkel auf dem Keramiksubstrat des Hybridbausteins;

Fig. 16

zeigt schließlich den elektrischen Schaltplan des Elektronikschalters.

Beschreibung der Ausführungsbeispiele

Die Darstellung der Fig. 1 zeigt, daß sämtliche für die gesteuerte (oder gegebenenfalls auch geregelte) Stromzuführung zu Akkugeräten, beispielsweise zu deren Drehzahlsteuerung, erforderlichen Baukomponenten in einem einheitlichen, geschlossenen Gehäuse angeordnet sind, und zwar auch und ausdrücklich der elektronische Hochleistungs-Halbleiterschalter sowie die meist vorgesehene Möglichkeit zur Rechts-Links-Drehrichtungsumschaltung des angetriebenen Akkugeräts.

Das bedeutet, daß der Elektronikschalter im Gegensatz zu den bisher bekannten Ausführungsformen lediglich und vorzugsweise über vier nach außen führende Hauptkontaktanschlüsse verfügt, nämlich über die beiden mit dem Akku zu verbindenden Anschlüsse 11a und 11b, die bei dem dargestellten Ausführungsbeispiel von unten aus dem Gerät herausschauen, sowie über zwei oben seitlich abgehende weitere Kontaktanschlüsse 12a, 12b, die die Motoranschlußklemmen bilden und aus dem Bereich des Rechts-Links-Umschaltersherrühren.

Bei allen Anschlußkontakten handelt es sich um Steckanschlüsse, die die Form von die Gerätewandung durchdringenden metallischen Kontaktzungen aufweisen, auf die, wie beispielsweise aus der Autotechnik bekannt, weiterführende Gegen-Kontaktklemmen aufgesteckt werden können. Auf diese Weise gelingt es auch, das Elektronikschaltergehäuse im wesentlichen staubdicht zu bekommen; die Durchführungsöffnungen im Gehäuse können eng anliegend toleriert werden oder es ist alternativ auch möglich, die jeweiligen, nach außen führenden Kontaktbahnen vom Gehäusematerial zu umspritzen.

Falls gewünscht können noch einige weitere zusätzliche Anschlüsse nach außen geführt werden, beispielsweise die beiden in der Darstellung der Fig. 1 mit 13a, 13b bezeichneten schmaleren Kontaktsteckanschlüsse für Leuchtdiodenanzeigen (eine Leuchtdiodenfarbe für Anzeige von Akkuunterspannung - eine weitere Leuchtdiodenfarbe zur Übertemperaturanzeige, was gleichzeitig einer automatischen Herunterregelung der Leistungsabgabe entspricht, hierauf wird weiter unten noch eingegangen).

Durch die spezielle Ausbildung der äußeren Kontaktanschlüsse in Form von Steckzungen ist auch eine große Anpassungsfähigkeit an unterschiedliche Raumverhältnisse möglich, da die Steckzungen beliebig abgebogen werden können, wie die beiden Motoranschlüsse 12a, 12b in Fig. 2 zeigen.

Oberhalb des Anlaß- oder Handdrückergriffs 14, der auf eine im Gehäuse geführten Drückerachse 15 sitzt, befindet sich der Rechts-Links-Umschalter-Hebel 16 der, wie für sich gesehen bekannt und aus der Fig. 2 ersichtlich, um eine feste Achse 17 in der Doppelrichtung des Pfeils A verschwenkbar gelagert ist und in einem Langloch 18 einen Schaltzapfen 19 aufnimmt, der durch eine Gehäuseöffnung eine Schaltwippe 20 (Fig. 9) betätigt. Zwischen dem Drückergriff 14 und dem Rechts-Links-Umschalterhebel 16 ist eine mechanische Verbindung vorgesehen, die so ausgebildet ist, daß der Rechts-Links-Umschalterhebel 16 nur dann betätigt werden kann, wenn der Drückergriff 14 sich in der Aus-Stellung befindet. Ein wesentlicher Grundgedanke vorliegender Erfindung ist aus der Darstellung der Fig. 1 in Verbindung mit den Fig. 3 und 4 erkennbar; die Aufteilung und Unterbringung sämtlicher, zum Teil sehr unterschiedlicher Arbeitskomponenten für den Elektronikschalter innerhalb eines einzigen, topfförmigen und mittels eines Deckels abgeschlossenen Gehäuses erfolgt so, daß das rechteckförmige Gehäuse in einer Ebene parallel zu seiner großen Querschnittsfläche unterteilt ist, so daß zunächst und in dieser Pakkungsrichtung aufeinanderfolgend in das topfförmige Gehäuse 21 (Fig. 4) ein großflächiger Hybridbaustein 22 angrenzend an den Gehäuseboden 21a eingelegt ist, von dem in Fig. 4 im wesentlichen lediglich das Keramiksubstrat 22a erkennbar ist, welches bei der hierdurch zur Verfügung gestellten größeren Grundfläche in der Lage ist, sämtliche elektrischen und elektronischen Baukomponenten aufzunehmen, hauptsächlich in der üblichen Dickschicht-Technologie, worauf weiter unten noch eingegangen wird. In der Ebene der Fig. 4 nach rechts schließt sich an den Hybridbaustein 22 mit Vergußrahmen 23 ein Schalterbereich 24 an, der sich nach oben bis in den Bereich der Drückerführung 25 fortsetzt. Oberhalb des Hybridbausteins 22 einerseits sowie des Schalterbereichs 24 und der Drückerführung 25 andererseits befindet sich, sich über die ganze Fläche erstreckend, jedoch innerhalb des einheitlichen Gehäuses angeordnet, der Bereich 26 der Rechts-Links-Umschaltung, von dem dann folgerichtig die weiter vorn schon erwähnten Motoranschluß-Steckzungen 12a, 12b ausgehen. Dabei befindet sich ein bisher nicht erwähnter, für die Gasgebefunktion des Elektronikschalters unerläßlicher Potentiometerbereich 27 in der Ebene der Fig. 4 links neben dem Bereich der Drückerführung 25, noch auf dem Keramiksubstrat 22a des Hybridbausteins 22 angeordnet und von einem gabelförmigen, in einer Lagerung in der Drückerachse 15 geführten Schleifer 28 kontaktiert.

Die insoweit angesprochene Lösung impliziert notwendigerweise, daß, was bei vorliegender Erfindung auch der Fall ist, im Gegensatz zu sämtlichen bisher bekannten Ausführungsformen, auch der kontinuierlich durchsteuerbare und daher unter Umständen mit hoher Verlustleistung beaufschlagte Halbleiter, über den der gesamte Versorgungsstrom für das an den Akku angeschlossene Gerät fließt, innerhalb des Elektronikschaltergehäuses und darüber hinaus, entsprechend einem bevorzugten Merkmal der Erfindung, als IC (beispielsweise in Form eines MOS-FET) auf der Platte des Keramiksubstrats 22a angeordnet ist.

Um die insofern gegensätzlichen Forderungen zu lösen, nämlich bei einer solchen Bauform für eine hinreichende Kühlung zu sorgen, ist auf der anderen Seite des Keramiksubstrats 22a, wie Fig. 4 zeigt, eine ausreichend dimensionierte Kühlplatte oder Kühlkörper 29 angeordnet, nämlich beispielsweise mit einem wärmeleitfähigen Kleber auf der Rückseite des Keramiksubstrats aufgeklebt. Bei diesem Kühlkörper 29 kann es sich um eine dickere Kupferplatte in den Abmessungen des Keramiksubstrats bzw. des von diesem mitgebildeten Hybridbausteins 22 handeln, wobei der Kühlkörper 29 durch eine Bodenöffnung 30 im topfförmigen Gehäuseteil 21 des Elektronikschaltergehäuses nach außen ragt.

Es ist dann möglich, in entsprechender Anlage an diesen Kühlkörper 29 von außen weitere Kühlmittel an das Elektronikschaltergehäuse heranzubringen und so für eine vollkommen hinreichende Zufuhr der hauptsächlich von dem Halbleiter erzeugten Verlustwärme zu sorgen, ohne daß es wie sonst notwendig ist, über eine Vielzahl von Leitungsverbindungen den Leistungsschalter an anderer Stelle im Gehäuse des zugehörigen Geräts mit guter Wärmeableitung anzuordnen, etwa dort festzuschrauben.

Da die Wärmeabfuhr über den großzügig dimensionierten Kühlkörper, der praktisch eine Seitenfläche des Elektronikschaltergehäuses (bis auf den darüberliegenden Rechts-Links-Umschalterbereich) einnimmt, unkritisch ist und entsprechend ausgelegt werden kann, gelingt es, in einem einheitlichen Kompaktgehäuse mit in diesem Fall dann nur noch sehr geringen Verdrahtungsaufwand für die verbleibenden vier Hauptanschlüsse über Steckzungen sämtliche Arbeitskomponente in diesem einem Gehäuse unterzubringen, so daß sich neben einer wesentlichen Montagevereinfachung überhaupt Aufbau, Kosten, Platzbedarf, universelle Anpassungsfähigkeit des Elektronikschalters entscheidend günstiger gestalten.

Zu aller Sicherheit ist dabei, worauf weiter unten noch bei der Besprechung der elektronischen Schaltung eingegangen wird, der den Halbleiterschalter (MOS-FET) umfassende IC so ausgelegt, daß er selbst bei Überschreiten vorgegebener Temperaturen bei Belastung abregelt, also seine Leistungsabgabe so weit drosselt, wie dies für seine Leistungsdaten maßgebend ist. Normalerweise setzt allerdings, wie Versuche bestätigt haben, eine solche Abregelung im praktischen Betrieb gar nicht ein, weil bei extrem starker Beanspruchung, wie für solche Elektronikschalter bei Akkugeräten ohnehin üblich, die IC-Schaltung überbrückt wird durch einen Bypaßschalter, während andererseits im gesteuerten Betrieb aufgrund der getroffenen Auslegung mit nach außen reichendem Kühlkörper 29 eine hinreichende Kühlmöglichkeit zur Verfügung steht, so daß die Abregelung nicht anzusprechen braucht.

Auf einen weiteren wesentlichen Gesichtspunkt bei vorliegender Erfindung kann ebenfalls sofort in Verbindung mit der Darstellung der Fig. 3 und 4 eingegangen werden; da der Schalterbereich 24 sich angrenzend zum Hybridbaustein 22 befindet, nämlich entsprechend Fig. 3 über diesem liegt, sind auf dem Keramiksubstrat 22a mit den dortigen Anschlüssen in entsprechender Weise elektrisch verbundene (hierauf wird weiter unten noch eingegangen) Kontaktbahnwinkel 32 befestigt, üblicherweise verlötet, wie dies Fig. 4 am besten zeigt. Diese Kontaktbahnwinkel stoßen dann rechtwinklig zu ihrer Auflagefläche auf dem Keramiksubstrat 22a durch die innerhalb des Vergußrahmens 32 befindliche Vergußmasse aus dem Hybridbaustein 22 nach außen und dienen mit ihrer vorspringenden Fläche unmittelbar als Kontaktstück für die einzelnen Schalter des Schalterbereichs 24.

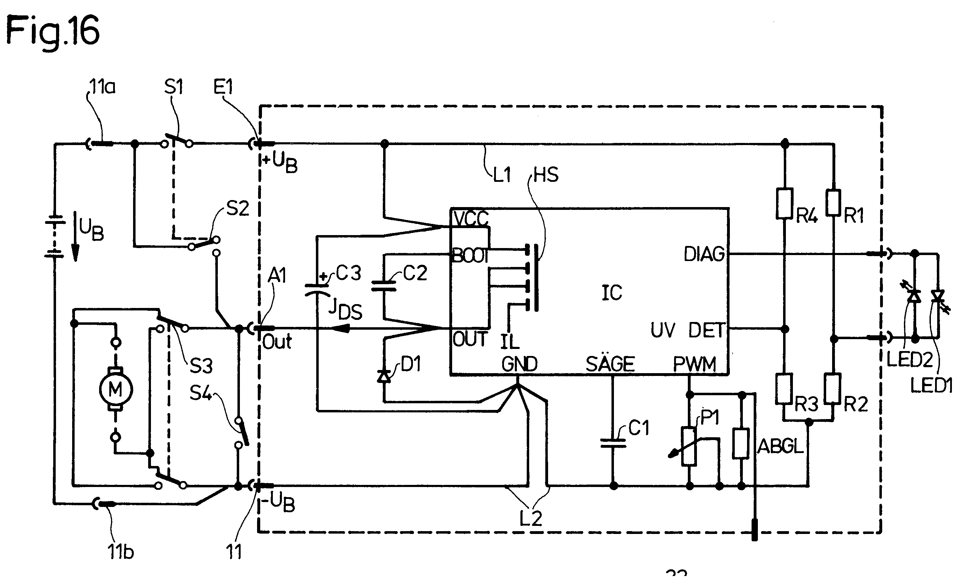

Um die wesentlichen, beim Aufbau des Elektronikschalters für Akkugeräte vorgesehene Einzelschalter besser zu unterscheiden und in die Gesamtkonzeption einzuordnen, ist es sinnvoll, anhand der Darstellung der Fig. 16 zunächst kurz auf den elektrischen Aufbau einzugehen.

Demnach ist das Herz des Hybridbausteins 22- (in Fig. 16 gestrichelt umrandet) gebildet von einem IC, der auch den Halbleiter-Leistungsschalter HS enthält, üblicherweise einen MOS-FET. Der innere Aufbau des IC ist bzw. kann jedenfalls von üblicher Struktur beispielsweise für eine Drehzahlregelung eines Gleichstrommotors M sein und wird weiter unten soweit erforderlich noch erläutert.

Die Versorgungsgleichspannung $U_B$ vom Akku gelangt über die schon erwähnten Kontaktzungen 11a, 11b (gleiche Bezeichnung wie in den Fig. 1 und 2) zum Elektronikschalter, wobei der mit dem negativen Pol des Versorgungsakkus verbundene Kontaktanschluß 11b zur negativen Masseschiene L2 der Schaltung durchverbunden ist; die positive Anschlußleitung ist mit L1 bezeichnet.

Es ist ein erster Ein/Aus-Schalter S1 vorgesehen, der den positiven Eingangskontaktanschluß an der Kontaktzunge 11a mit dem Hybridbaustein 22 bzw. mit der von diesem gebildeten Schaltung verbindet; über einen den Eingangsanschluß E1 und den Ausgangsanschluß A1 des Hybridbausteins überbrückenden Vollastschalter S2 wird der Pluspol unter Umgehung der Steuerungsschaltung direkt mit dem einen Motoranschluß (entsprechend Ausgangsanschluß A1 der Steuerschaltung) verbunden.

Es ist dann noch ein weiterer Schalter S4 vorgesehen, der die Motoranschlußklemmen entsprechend Ausgangsanschluß A1 der Steuerschaltung sowie Masseanschluß M kurzschließt; dieser Schalter wird entsprechend seiner Wirkung als Bremsschalter bezeichnet.

Ein vierter Schalter S3 dient schließlich der Rechts-Links-Umschaltung der Motordrehrichtung und verfügt über entsprechende Doppelkontakte.

Von den erwähnten Schaltern wird der Eingangsschalter S1, der Vollastschalter S2 und der Bremsschalter S4 durch die Betätigung des Drückers geschaltet, während der Rechts-Links-Schalter S3 separat durch den Schwenkschalter 16 oberhalb des Handdrückergriffs 14 betätigt wird.

Dementsprechend befinden sich auch Eingangsschalter S1 und Vollastschalter S2 in dieser Reihenfolge unterhalb der Drückerführung 25 angeordnet, wenn man zur Darstellung der Fig. 3 und 4 zurückkehrt, wobei die Fig. 3 die Position der Drückerführung bei losgelassenem Drückerhandgriff in der Aus-Schaltstellung zeigt.

Die Drückerachse 15, die die Gehäuseeintrittsöffnung 32 beispielsweise noch als Rundachse durchsetzen kann, verändert sich innerhalb des Gehäuses in Form, Außenabmessungen und Struktur erheblich, um die verschiedenen Aufgaben erfüllen zu können.

Wie die Darstellung in den Fig. 3 und 8 zeigt, geht die Drückerachse 15 in ein grob rechteckförmiges, mit Abschrägungen und Einschnitten versehenes inneres Drückerteil 33 über. Unterhalb des Drückerteils 33 in der Darstellung der Fig. 3 befinden sich, eingesetzt und gehalten von inneren zum Gehäuse 21 einstückigen Wandformern 35 die Strukturen für den Eingangsschalter S1 und den Vollastschalter S2, nebeneinander angeordnet und jeweils bestehend aus einem Schalterstößel 35a, 35b, der, jeweils nach oben in der Darstellung der Fig. 3 und 4 vorgespannt von einer kräftigen Vorspannungsfeder 36a, 36b, eine metallische Kontaktbrücke 37a, 37b lagert.

Die Schalterstößel 35a, 35b verfügen jeweils über obere Gleitflächen 38, die mit einer unteren, eine Schrägfläche umfassende Nockenlaufbahn 39 am inneren Drückerteil in Wirkverbindung stehen. In der Darstellung der Fig. 3 ist das innere Drückerteil 33 von einer eigenen, starken Vorspannungsfeder 40 in die Aus-Schaltstellung an die rechte Anschlagposition gedrückt, in welcher die beiden Schalterstößel 35a, 35b gegen ihren eigenen Federdruck nach unten verschoben sind; in dieser Position befinden sich die oberen Gleitflächen 38 der beiden Schalterstößel in der strichpunktierten Position 38' bzw. 38". Die freie Verschiebewegstrecke für das innere Drückerteil 33 ist in Fig. 3 durch den Abstand B gekennzeichnet; wird jetzt durch Druckausübung auf den Drückerhandgriff 14 über die Drückerachse 15 das innere Drückerteil 33 in der Zeichenebene der Fig. 3 allmählich nach links verschoben, dann läuft zunächst der Schalterstößel 35a, mit seiner oberen Gleitfläche 38 dem schrägen Verlauf der Nockenbahn 39 folgend, nach oben und nimmt hierbei unter der Wirkung seiner eigenen Federvorspannung die Kontaktbrücke 37a mit. Hierdurch gelangt der erste Eingangsschalter S1 in seine leitende Schließposition - die Schaltung des Hybridbausteins 22 wird mit Spannung versorgt und gleichzeitig wird, worauf weiter unten noch eingegangen wird, ein Schiebepotentiometer bei weiterem Eindrücken des Drückers betätigt, so daß von dem IC am Ausgang A1 Ausgangsstrom für den Motor M je nach Drückerposition zur Verfügung gestellt wird (Fig. 16).

Wird der Drückerschalter vollständig durchgedrückt, also in die linksseitige Anschlußposition der Fig. 3 verschoben, dann schließt schließlich auch der zweite Vollastschalter S2 und überbrückt die elektrische Schaltung der Fig. 16 mit IC, wodurch dem Motor M die volle Versorgungsspannung des Akkus zugeführt wird (kein lückender Betrieb).

Die auf den Drücker wirkende starke Vorspannungsfeder 40 ist über einen größeren Teil ihrer Länge auch in der voll ausgefahrenen Position wie in Fig. 3 dargestellt in einer entsprechend geformten Ausnehmung 41 im inneren Drückerteil 33 verkantungsfrei geführt und wird auf der entgegengesetzten Seite von einer napfartig vorstehenden Fassung 42 gehalten.

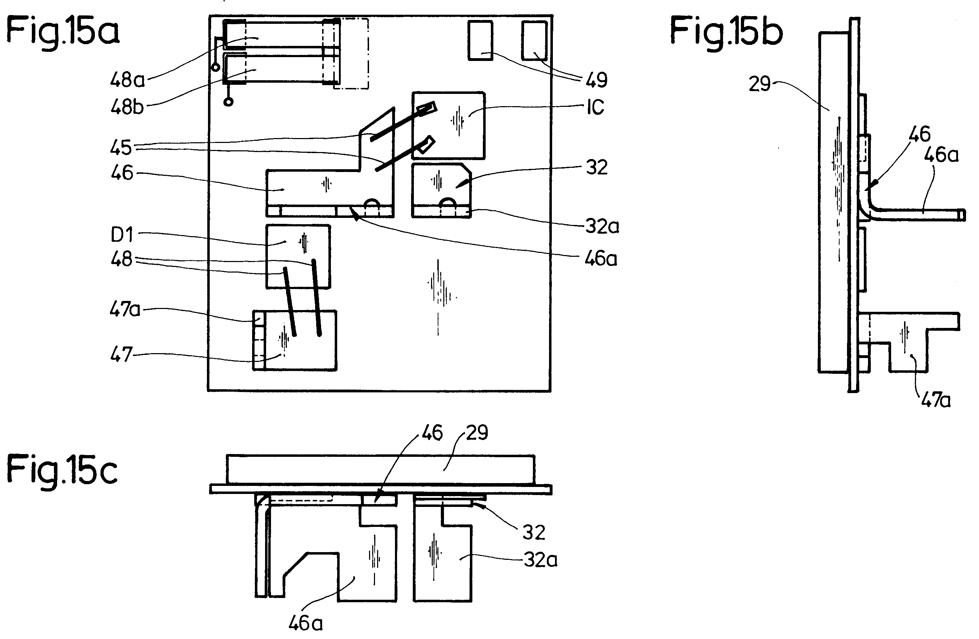

Um den Stromlaufplan und insofern auch die Verteilung der einzelnen Komponenten innerhalb des Schaltergehäuses besser verstehen zu können, wird nunmehr zunächst in Verbindung mit den Darstellungen der Fig. 15a, 15b und 15c die Kontaktbahnwinkel-Verteilung auf dem Keramiksubstrat 22a des Hybridbausteins 22 erläutert.

Fig. 3 zeigt, daß die (Plus-Spannung vom Akku führende) Eingangssteckzunge 11a (einstückig) in eine erste innere Kontaktbahn 44 übergeht, die mit einer horizontalen Abbiegung 44a über beiden Kontaktbrücken 37a, 37b der Schalter S1, S2 liegt und auf diese Weise direkt das jeweilige Eingangskontaktstück für diese Schalter bildet. Weiter vorn wurde schon erwähnt, daß die Ausgangskontaktstücke für diese Schalter direkt von Kontaktwinkeln gebildet sind, die vom Substrat 22a des Hybridbausteins ausgehen und betrachtet man die Darstellung der Fig. 15a, dann erkennt man, daß auf der Platte des Keramiksubstrats 22a (neben anderen Komponenten, auf die nicht eingegangen zu werden braucht oder die weiter unten noch erläutert werden) ein erster Kontaktwinkel 32 angeordnet ist, der mit einer senkrecht abstehenden Fläche 32a unmittelbar das innere Gegenkontaktstück für den Eingangsschalter S1 bildet. Über diesen Kontaktwinkel 32 gelangt also die positive Versorgungsspannung zur Schaltung des Hybridbausteins 22 und wird über eine untere Kontaktflächenverbindung zu dem (soweit gewünscht auch jeweils kundenspezifisch ausgelegten) IC geleitet. An diesem ergibt sich die jeweils gewünschte Stromsteuerung (wird noch erläutert); der Ausgang des IC ist über einen (vorzugsweise wegen der hohen Strömen doppelte) Dickdrahtbondung 45 auf einen zweiten Kontaktwinkel 46 geführt, dessen ebenfalls senkrecht abstehender Schenkel 46a sowohl den Ausgangsanschluß A1 der Steuerschaltung als auch, wie aus Fig. 16 erkennbar, den inneren Kontaktstück-Anschluß für den zweiten Vollastschalter S2 bildet.

Der Vollständigkeit halber wird noch darauf hingewiesen, daß sich auf dem Keramiksubstrat 22a noch die Freilaufdiode D1 befindet, die entsprechend der Schaltung der Fig. 16 den Ausgangsanschluß des Kontaktwinkels 46, mit dem sie über das Substrat verbunden ist, mit einem weiteren Masseanschluß-Kontaktwinkel 47 verbindet, und zwar ebenfalls über eine entsprechende Dickdrahtbondung 48. Auch der weitere Kontaktwinkel 47 für den Masseanschluß verfügt über einen hochgebogenen Schenkel 47a, wobei der Schenkel 47a und der (Doppel)-Schenkel 46a des Kontaktstückes 46 als Ausgang A1 jeweils Lötstellenanschlüsse für weitere Innenkontaktbahnen des Elektronikschalters bilden, auf die gleich eingegangen wird.

Der Aufbau auf dem Keramiksubstrat vervollständigt sich durch auf diesem aufgedruckte Potentiometerbahnen 48a, 48b sowie durch zwei (verzinnte) Anschlußflächen 49 für die weiter vorn schon erwähnten LED's, zur fakultativen Verbindung mit den nach außen geführten Anschlüssen 13a, 13b der Fig. 1.

Die weitere Stromführung innerhalb des Gehäuses des Elektronikschalters erfolgt so, daß ausgehend von der äußeren Eingangs-Steckzunge (für den negativen Pol des Versorgungsakkus), die ihrerseits in eine innere, vergleichsweise kompliziert gestaltete und verlaufende Kontaktbahn 50 übergeht, zunächst eine elektrische Verbindung 51 hergestellt ist zwischen einem ersten, von der Kontaktbahn 50 wegstehenden Flügel 50a und dem Minusanschluß-Kontaktwinkel 47 des Hybridbausteins 22.

Die Kontaktbahn 50 verläuft dann, wie insbesondere auch die Darstellung der Fig. 6 genauer zeigt, längs der inneren Gehäusewandung des Elektronikschalters nach oben und bildet dann einen horizontal abgebogenen Schenkel 50b, wie dies am besten der Darstellung der Fig. 11, 12 und 13 entnommen werden kann. Im oberen Gehäusebereich erfüllt dieser Kontaktbahnverlauf noch zwei weitere Aufgaben, und zwar bildet ein vom horizontalen Schenkel 50b hochgeklappter, flach abgebogener Lappen 50c den einen (Minus)Anschlußpol für die Rechts-Links-Umschaltung im Kopf des Elektronikschaltergehäuses, während ein wieder nach unten abgebogener kurzer Schenkel 50d der inneren Kontaktbahn 50 ein erstes Kontaktstück für den Bremsschalter S4 bildet, auf den noch eingegangen wird (vergl. Fig. 8).

Im allgemeinsten Fall einer vom IC getaktet dem Motor zur Verfügung gestellten Steuerspannung (im gesteuerten Betrieb und bei geöffnetem Vollastschalter S2) wird diese von dem Ausgangs-Kontaktwinkel 46a zu einer weiteren inneren Kontaktbahn 52 als weiterer Stromleiter innerhalb des Elektronikschaltergehäuses geführt. Diese zweite Kontaktbahn 52 ist kürzer als die soeben besprochene Kontaktbahn 50, deshalb, weil sie nicht nach außen geführt zu werden braucht; sie beginnt, wie Fig. 6 zeigt, als weitere elektrische Verbindung 53, beispielsweise Handlötverbindung, wie auch bei 51 und wird im folgenden nur noch so bezeichnet, mit einem Querlappen 52a, der an den Kontaktbahn-Schenkel 46a angelötet ist, verläuft dann angrenzend und parallel zur Kontaktbahn 50 (in Fig. 3 unterhalb dieser) ebenfalls nach oben und bildet dann im wesentlichen die gleichen, jedoch komplementären Formen und Funktionen aus, wie mit Bezug auf die Kontaktbahn 50 schon erläutert und wie in Fig. 14 auch dargestellt, d.h. ein oberer Horizontalschenkel 52b geht in einen zweiten nach oben geklappten breitflächigen Lappen 52c über und endet in ein nach unten gebogenes Teilstück 52d als zweites Kontaktstück für den Bremsschalter S4 (Fig. 8).

Der Bremsschalter S4 ist selbst mit seinem brückenförmigen Schaltstück 53 am inneren Drückerteil 33 gelagert, wo das Schaltstück 53 (Fig. 8) von einer Überdeckung 54 des Drückerteils 33 beweglich gehalten, von einer eigenen kleinen Vorspannungsfeder 55 bis zu einem inneren Anschlag am Drückerteil 33 in der Zeichenebene der Fig. 8 nach rechts gedrückt ist.

Man erkennt, daß sich der Kurzschlußschalter S4 dann öffnet, wenn sich die Drückerführung 25 auch nur geringfügig nach innen bewegt, also noch bevor der Eingangsschalter S1 seine Kontakte schließen kann. Andererseits wird durch die geringe Eigenbeweglichkeit mit eigener Vorspannungsfeder 55 am Kurzschlußschalter S4 sichergestellt, daß die elektrische Kontaktgabe zwischen dem brückenförmigen Schaltstück 53 und seinen beiden Gegenkontaktstücken 50d, 52d (herrührend von den inneren Kontaktbahnen 50 und 52) unter allen Umständen in der Aus-Position des Drückers sichergestellt ist, da das Schaltstück 53 gegen eigene Federvorspannung in der rechten Anschlagposition des inneren Drückerteils 33 noch geringfügig zurückweicht und einwandfrei kontaktiert; wird dann der Drücker beim Anlassen des Geräts wieder eingedrückt, dann gelangt das brückenartige Schaltstück 53 an eine seiner inneren Form entsprechende Anschlagwandung 56 (gestrichelt in Fig. 8), die Kontakte lösen sich und als nächstes schließt der Eingangsschalter S1.

Aus der Darstellung der Fig. 8 kann man noch die abgewinkelte Form des Potentiometerschleifers 28 erkennen, der längs der Potentiometerbahnen 48a, 48b auf dem Keramiksubstrat 22a gleitet und diese beiden Bahnen miteinander verbindet, so daß sich die in Fig. 16 bei P1 angedeutete Potentiometerfunktion für die angenommene Drehzahlsteuerung des akkuversorgten Geräts ergibt.

Fig. 7 zeigt noch einmal deutlicher die Lage der beiden inneren Kontaktbahnen 50 und 52 mit ihren jeweiligen seitlichen Vorsprüngen, den beiden Verbindungsbereichen (Handlötstellen 51, 52 und 53) sowie dem Hybridbaustein 22, bestehend aus dem Keramiksubstrat 22a mit den beiden Kontaktstücke für die Schalter S1 und S2 bildenden Kontaktschenkeln 32a, 46a und dem Vergußrahmen 23. Man erkennt, daß die Platte des Keramiksubstrats 22a seitlich auf den inneren Öffnungsrändern 30a des Bodenausschnittes 30 des Gehäuses aufliegt und lediglich der Kühlkörper 29 aus dem Gehäuse zur weiteren Kontaktierung und Wärmeableitung herausragt. Das Gehäuse ist von einem Deckel 21a abgeschlossen und die Einzelteile des Elektronikschalters sind so ausgebildet und sortiert, daß die Montage von der vom Deckel befreiten Seite des dann schachtelförmigen Gehäuses ausgehend so erfolgen kann, daß diese Teile aufeinanderfolgend in das Gehäuse eingestapelt oder eingelegt werden, so daß schließlich auch eine automatische Montage, falls gewünscht, möglich ist.

Der Gesamtaufbau des Elektronikschalters vervollständigt sich noch durch die Ausbildung des Rechts-Links-Umschalters so, wie dies am besten der Fig. 9 entnommen werden kann. Im oberen Teil des Gehäuses 21 ist ein inneres Teilgehäuse 57 für den Rechts-Links-Schalter S3 eingelegt, welches Kontaktbahnen und Kontaktwinkel zur Rechts-Links-Umschaltung aufnimmt bzw. auf diesem auch aufliegt, wie die Fig. 10 zeigt. Das innere Teilgehäuse 57 sichert die Relativposition der aus der Draufsicht der Fig. 9 am besten zu erkennenden Schalterstrukturen für die Rechts-Links-Umschaltung, wobei die Kontaktlappen 50c und 52c die Stromversorgung bilden und nach oben bringen - der Kontaktlappen 50c für den Masseanschluß und 52c bezüglich der gesteuerten (lückenden) Gleichstromversorgung als positiven Spannungsanschluß bzw. volle Versorgungsspannung bei geschlossenem Schalter S2.

8

Die beiden Kontaktlappen 50c und 52c liegen sich einander gegenüber und weisen eine schwach halbmondförmige Form auf; es sind ferner zwei bewegliche Kontaktwippen 58a und 58b vorgesehen, die in ständigem elektrischen Kontakt mit inneren Lagerklemmen-Winkeln 59a, 59b stehen, die ihrerseits nach außen in die zu den Motoranschlüssen führenden Steckzungen 12a, 12b bevorzugt einstückig übergehen. Auch hier dient die Aufnahme durch ein inneres Teilgehäuse 57 der entsprechenden Fixierung und Positionierung dieser Schaltelemente, wobei die Kontaktwippen 58a, 58b eine etwa halbkugelförmig gekrümmte Form aufweisen und jeweils mittig von gabelförmigen Endbereichen 60 der inneren Lagerklemmen aufgenommen sind. Man erkennt, daß je nach Winkelposition der entsprechend dem Doppelpfeil C verdrehbaren Schaltwippe 20 die Kontaktwippen 58a, 58b jeweils gegenläufig die Kontaktlappen 52c und 50c berühren, so daß an den Ausgangs-Steckzungen 12a, 12b je nach Position der Schaltwippe 20 eine in ihrer Polarität wechselnde Ausgangsspannung anliegt.

Die Schaltwippe 20 enthält in ihrem Inneren gelagert auf beiden Seiten jeweils mittels kleiner Federn 61 vorgespannte Druckstücke 62, so daß die Kontaktgabe zwischen den Kontaktwippen und den Kontaktlappen 50c, 52c einwandfrei ist.

Die Umschaltung der Schaltwippe 20 in ihre jeweils andere Winkelposition mit Hilfe des Schalthebels 16 für den Rechts-Links-Schalter kann so erfolgen, wie in Fig. 5 oben gezeigt; ein Schwenksteg 16a des Schalthebels 16 erfaßt mittels des erwähnten Langlochs 18 einen aus seiner oberen Gehäuseöffnung 63 hervorragenden Schwenkzapfen 19, der seinerseits in geeigneter Weise mit der verschwenkbaren Schaltwippe 20 verbunden ist. Die Integration gerade auch des Rechts-Links-Umschaltbereichs innerhalb des geschlossenen Gehäuses für den Elektronikschalter ist besonders vorteilhaft, weil auf diese Weise in einer ungewöhnlich kompakten, nach außen abgedichteten Bauform sämtliche Arbeitskomponenten ohne äußeren Verdrahtungsaufwand integriert sind und vor allen Dingen durch die Konzeption abgedichtet die Gehäusewandungen durchdringender Steckzungen auch im rauhen Betrieb nicht befürchtet zu werden braucht, daß Fremdkörper oder Staub in das Innere des Schalters eindringen. Daher vervollständigt sich der Aufbau im Bereich der Drückerführung noch durch eine zusätzliche Dichtung 64 (Fig. 3), die von einer Dichtrillenaufnahme 65 im Bereich der Durchführung der Drückerachse 15 in das Gehäuseinnere angeordnet ist und diese Achse einwandfrei abdichtend umgibt.

Eine weitere vorteilhafte Ausgestaltung besteht darin, daß durch die sinnvolle Konstruktion der inneren metallischen kräftigen bandförmigen Kontaktbahnen eine mögliche Verformungsarbeit, die die sehr kräftige Drückerfeder beispielsweise auf die Gehäusewandungen ausüben könnte, sozusagen aufgefangen wird, und zwar auf folgende Weise.

Wie am besten die Fig. 6 zeigt, laufen die inneren Kontaktbahnen 50 und 52, die schmale Gehäuse-Querseite innen praktisch ausfüllend von unten nach oben, wobei dann bei beiden Kontaktbahnen 50 und 52 in der mit X gekennzeichneten Höhe der horizontale Schenkel 50b, 52b abgeht, der sich quer über die gesamte Breite des Gehäuses erstreckt, bis dieser Schenkel einstückig in die wieder nach unten abgebogenen kurzen Kontaktschenkel 50d, 52d übergeht. Der Hauptquerschenkel 50b, 52b verläuft daher parallel zur Vorspannungsfeder 40 für den Drücker, und da bei losgelassenem Drückergriff 14 der innere Drückerteil 33 mit dem von ihm gelagerten Bremsschalter S4 über dessen Kontaktbrücke 53 voll entlastet an den kurzen Kontaktschenkeln 50d, 52d anliegt, erkennt man, daß sich die Drückerfeder 40 (indirekt) auf beiden Seiten auf die metallischen Kontaktbahnen abstützt, denn die napfartige Fassung 42 liegt als Kunststofformteil mindestens über der nach oben laufenden Kontaktbahn 50. Die Drückerfeder 40 wird daher in ihrem kräftigen Expansionsdrang nach beiden Querseiten von mindestens einer der Kontaktbahnen sozusagen zusammengehalten und in ihren Auswirkungen sicher von dem Gehäuse ferngehalten.

Es sei noch erwähnt, daß die einzelnen Baugruppen und Komponenten innerhalb der rechteckförmigen Schachtelform des Gehäuses 21 sortiert und gehalten sind durch Gehäuseeinsätze, die weiter vorn schon kurz erwähnt worden sind und aus stegartigen Unterbrechungen, Zwischenwänden und Trennwänden bestehen. So erstreckt der Gehäuseteilwand-Einsatz 35 für die Schalter S1 und S2 sich mit einer vorzugsweise einstückig angeformten inneren Teilquerwand 35' in der Zeichenebene der Fig. 3 zunächst nach links und dann als senkrecht verlaufender Schenkel 35'' nach oben, wodurch bei gleichzeitiger Bedeckung mindestens der Kontaktbahn 50 auch die napfförmige Fassung 42 für die Drückerfeder 40 gebildet wird.

Unterhalb des Bereichs der Rechts-Links-Umschaltung sind also in die Gehäuseschachtelform zunächst eingelegt der IC-Baustein 22 mit nach außen ragendem Kühlkörper; auf dessen Vergußrahmen 23 ist die innere vielwandige Gehäusestruktur 35, 35', 35'' aufgelegt, die ihrerseits wiederum die Stößel 35a, 35b einschließlich Schaltmechanismus und Vorspannungsfedern 36a, 36b der beiden Schalter S1, S2 lagert. Oberhalb der Schalter S1, S2 kommt das innere Drückerteil 33 zu liegen, dessen obere Kanten gleichzeitig Gleitflächen 33a, 33b, 33c bilden, mit welchen das Drük-

kerteil 33 längs der unteren Flächen der quer geführten Kontaktbahnen 50, 52, also deren Querschenkel 50b, 52b gleitet und diese auch als Gleitführung benutzt.

Darüber befindet sich dann das Einsatzteilgehäuse 57 für die Rechts-Links-Umschaltung; betrachtet man hier die Darstellung der Fig. 9, dann erkennt man auch, daß dieses Teilgehäuse mit Vorsprüngen 57a, 57b entsprechende Öffnungen 66 des Gehäuses 21 bzw. des Deckels 21a eng anliegend (wegen der Staubdichtigkeit) durchsetzt und so auch die oberen Motoranschluß-Steckzungen nach außen führt.

Zu dem Hybridbaustein 22 kann noch folgendes festgestellt werden. Es wird ein Keramiksubstrat aus Aluminiumoxid vorgegebener Dicke verwendet, bei dem Leiterbahnen in Siebdruckverfahren aufgebracht, getrocknet und eingebrannt werden. Widerstände und Potentiometer können ebenfalls im Siebdruckverfahren aufgebracht oder als SMD-Bauelemente, wie Kondensatoren auch, realisiert werden. Der Kontaktwinkel 32 dient zur Spannungsversorgung ($+U_B$-Anschluß) des Hybrids und gleichzeitig als Festkontakt für den Eingangsschalter S1. Der Kontaktwinkel 46 dient als Ausgangsanschluß der Schaltung und gleichzeitig als weiterer Festkontakt für den Vollastschalter S2 als Bypass-Schalter für den IC. Dabei ist der hochstehende Schenkel 46a dieses Kontaktwinkels 46 nach Art eines Doppelschenkels ausgebildet, um gleichzeitig eine Handlötstelle zur Verbindung mit der kürzeren Kontaktbahn 52 zu schaffen. Die zweite Handlötstelle wird dann durch den hochstehenden Schenkel 47a des Kontaktwinkels 47 für den Masseanschluß des Hybrids gebildet.

Eine Verbindung zu weiter vorn schon kurz erwähnten Leuchtdioden beispielsweise zur Anzeige von Übertemperatur und Unterspannung kann mit Blattfedern hergestellt werden, die auf den Anschlußflächen 49 für die LED's federnd aufliegen.

Die beiden Potentiometerbahnen 48a, 48b werden von dem gabelförmigen Schleifer 28 verbunden und werden mit wachsendem Zustellweg bis zum Widerstand Null überbrückt. Insofern ist kein Schleiferabgriff vorgesehen, und das Potentiometer ist als veränderlicher Widerstand realisiert.

In Verbindung mit der Schaltungsdarstellung der Fig. 16 und den vorhergehend besprochenen Aufbaubildern läßt sich zur Funktion feststellen, daß durch Schließen des Eingangsschalters S1 bei anfänglichem Eindrücken des Drückergriffs 14 die Elektronik in Betrieb gesetzt wird, da der Minusanschluß des Akkus von Anfang an über die Kontaktbahn 50 mit Außenanschluß entsprechend Steckerzunge 11b durchverbunden ist.

Die Steuerung des Hybridbausteins arbeitet nach dem Verfahren der Puls-Weiten-Modulation; die Erhöhung bzw. Erniedrigung des über den Rechts-Links-Schalter dem Motor zugeführten Stroms erfolgt durch Verbreiterung bzw. Verschmälerung von Stromimpulsen ansonsten konstanter Höhe und Frequenz. Durch den Kondensator C1 entsprechend Fig. 16 wird die Taktfrequenz der Strompulse bestimmt; sie kann bei einem gewählten Ausführungsbeispiel, welches die Erfindung natürlich nicht einschränkt, 22 kHz betragen.

Die Pulsweite wird mit dem Potentiometer P1 geregelt, wobei die Höhe des Widerstandes und damit die am Eingang PWM anliegende Spannung als Schwelle für eine am Eingang SÄGE (Sägezahngenerator) auftretende Spannung dient.

Der Aufbau der sich um den Steuerbaustein IC gruppierenden restlichen Schaltungselemente vervollständigt sich durch eine Freilaufdiode D1, die dem Schutz der Elektronik bei Abschalten des Akkus durch den Eingangsschalter S1 dient; der Kondensator C3 glättet durch eventuelle hohe Stromimpulse an den Leitungsinduktivitäten entstehende Spannungsimpulse und schützt den IC gegen Überspannung, während die LED1 anspricht, wenn die Versorgungsspannung des Akkus unter einen bestimmten Wert gesunken ist, der durch die beiden Widerstände R3 und R4 bestimmt wird, und die LED2 eine Überlastung der Elektronik signalisiert (zu heiß). Die Widerstände R1 und R2 dienen einer Begrenzung des durch die Leuchtdioden LED1 und LED2 fließenden Diodenstroms.

Weiter vorn wurde schon erwähnt, daß die Steuerschaltung eine Stromregulierung durch Temperaturbegrenzung einführt; erreicht der Schaltungsbaustein IC eine bestimmte Temperatur, die beispielsweise zwischen 140 bis 170 °C liegen kann, dann leuchtet die LED1 auf,und gleichzeitig steuert eine Temperaturregelung die Pulsweite zurück, und zwar um so stärker, je höher die Chip-Temperatur wird. Diese Temperaturregelung schützt die gesamte Elektronik vor Übertemperatur; infolge der sehr wirksamen Kühlung spricht diese aber, wie Versuche ergeben haben, im Normalbetrieb praktisch nicht an. Sie kann ohnehin durch Übergang in den Vollastbetrieb willkürlich ausgeschaltet werden, was dem IC gleichzeitig Gelegenheit gibt, entsprechend abzukühlen.

Abschließend wird darauf hingewiesen, daß die Ansprüche und insbesondere der Hauptanspruch Formulierungsversuche der Erfindung ohne umfassende Kenntnis des Stands der Technik und daher ohne einschränkende Präjudiz sind. Daher bleibt es vorbehalten, alle in der Beschreibung, den Ansprüchen und der Zeichnung dargestellten Merkmale sowohl einzeln für sich als auch in beliebiger Kombination miteinander als erfindungswesentlich anzusehen und in den Ansprüchen niederzulegen sowie den Hauptanspruch in seinem Merkmalsgehalt zu reduzieren.

## Patentansprüche

1. Vorrichtung zur Steuerung oder Regelung des Betriebs von durch Akkus oder Batterien versorgter Geräte (Akkuschalter), insbesondere zur Stromsteuerung von Elektro(hand)geräten wie Akkuschrauber, Akkubohrer u. dgl., mit einem Gehäuse, einem äußeren, verschiebbaren Drückergriff am Gehäuse und einer elektrischen, durch die Drückergriffverschiebung in ihrer Funktion vorzugsweise infolge Potentiometerverstellung gesteuerten Schaltung mit mindestens einem Leistungshalbleiter, dadurch gekennzeichnet, daß der Leistungshalbleiter (MOS-FET;HS), über den der Stromfluß zum Gerätemotor gesteuert ist, auf einer gehäuseinternen Schaltungsplatte angeordnet ist, die ihrerseits einen Kühlkörper (29) großflächig kontaktiert, der durch eine Gehäusedurchbrechung (30) frei nach außen ragt.

2. Vorrichtung nach Anspruch 1, dadurch gekennzeichnet, daß der Leistungshalbleiter (HS) als MOS-FET Teil einer integrierten Schaltung (IC) ist, die ihrerseits großflächig auf der gehäuseinternen Schaltungsplatte in Form eines Keramiksubstrats (22a) angeordnet ist derart, daß über das Keramiksubstrat (Aluminiumoxidkeramik) die Wärmeableitung und insbesondere die Ableitung der vom IC erzeugten Verlustwärme auf den Kühlkörper (29) erfolgt, der eine großflächig mit der Rückseite des Keramiksubstrats (22a) gut wärmeleitend verklebte dicke Kupferplatte ist.

3. Vorrichtung nach Anspruch 1 oder 2, dadurch gekennzeichnet, daß der den Halbleiterleistungsschalter (MOS-FET HS) enthaltende IC eine interne Stromregelung durch Temperaturbegrenzung aufweist derart, daß bei Überschreiten eines vorgegebenen Grenztemperaturbereichs die den Leistungshalbleiter durchfließende Strommenge zurückgenommen wird.

4. Vorrichtung nach einem der Ansprüche 1-3, dadurch gekennzeichnet, daß auf dem Keramiksubstrat (22a) Leiterbahnen und Widerstände einschließlich Potentiometerbahnen im Siebdruckverfahren oder als SMD-Bauelemente aufgebracht sind und ein Vergußrahmen (23) vorgesehen ist, der wesentliche Teile der elektrischen Schaltungselemente auf dem Keramiksubstrat (22a) überdeckt und durch eingebrachte Vergußmasse abdeckt.

5. Vorrichtung nach einem oder mehreren der Ansprüche 1-4, dadurch gekennzeichnet, daß die Stromführung auf dem Keramiksubstrat (22a) durch auf dessen Oberfläche großflächig aufgesetzte und verlötete Kontaktstücke und Kontaktwinkel erfolgt, mit Dickdrahtbondung zwischen den Kontaktstücken, sonstigen Schaltungselementen (Freilaufdiode D1) und dem IC-Baustein, wobei die aufgesetzten Kontaktwinkel (32, 46, 47) mit ihren wegstehenden Kontaktschenkeln (32a, 46a, 47a) der äußeren Anschlußbildung dienen.

6. Vorrichtung nach einem oder mehreren der Ansprüche 1-5, dadurch gekennzeichnet, daß die elektrische Schaltung einen Taktgenerator enthält zur Bestimmung der Frequenz der bei Steuerung der externen Last zugeführten Stromimpulse mit konstanter Höhe, wobei die Modulation der Strommenge durch Verbreiterung bzw. Verschmälerung der Stromimpulse entsprechend der durch die Drückerposition bestimmten Potentiometerstellung bestimmt ist.

7. Vorrichtung nach einem der Ansprüche 1-6, dadurch gekennzeichnet, daß sämtliche Schaltungskomponenten der elektrischen Schaltung einschließlich des Leistungshalbleiters (MOS-FET HS) innerhalb des geschlossenen, nur auf einer Seite von dem Kühlkörper (29) großflächig durchbrochenen Gehäuses (21) angeordnet sind.

8. Vorrichtung nach Anspruch 7, dadurch gekennzeichnet, daß das Gehäuse (21) schachtelförmig zweiteilig ausgebildet ist und in einem oberen, sich über die gesamte Gehäusedicke erstreckenden schmaleren Abteil einen Rechts/Links-Umschalter mit eigener innerer Gehäusewandstruktur (57) aufnimmt, daß sich nach unten an den Rechts/Links-Umschalterbereich (26) und angrenzend an die im Querschnitt großflächige Gehäusebodenfläche (21a) zunächst ein plattenförmiger Hybridbaustein (22) anschließt, über welchen sich angrenzend zum Bereich der Rechts/Links-Umschaltung der innere, gegen Federdruck bewegliche Drückerbereich (25) erstreckt, unterhalb welchem und über dem Hybridbaustein (22) ein Schalterbereich (24) angeordnet ist, der durch die Verschiebung des inneren Drückerteils (33) betätigbar ist.

9. Vorrichtung nach einem der Ansprüche 1-8, dadurch gekennzeichnet, daß der Schalterbereich (24) von einer internen Teilgehäuse-Wandstruktur (35) gebildete Stößelführungen umfaßt für zwei Schalter (Eingangsschalter S1; Vollastschalter S2), die im Verlauf der Drückereinwärtsbewegung aufeinanderfolgend geschaltet sind und daß die Schalterstößel (35a, 35b) in ihren Lagerungen durch jeweils eigene Vorspannungsfedern (36a, 36b) mit Nockengleitflächen (38) gegen eine untere Nockengleitbahn (39) mit schrägkante am inneren Drückerteil (33) gepreßt sind.

10. Vorrichtung nach einem der Ansprüche 1-9, dadurch gekennzeichnet, daß die Schalternocken (35a, 35b) metallische Kontaktbrücken (37a, 37b) lagern, die stationäre Festkontakte verbinden.

11. Vorrichtung nach einem der Ansprüche 1-10, dadurch gekennzeichnet, daß zwei aus dem Gehäuse nach außen durch Schlitze ragende, mit den Akkuanschlüssen zu verbindende Steckzungen (11a, 11b) im Gehäuseinneren einstückig als aus metallischem Bandmaterial gebildete Kontaktbahnen (44, 50) weitergeführt sind, wobei die mit dem negativen Pol verbundene Kontaktbahn (50) längs der hinteren Gehäuseschmalfläche auf der zum Drückergriff (14) abgewandten Seite innen verläuft und bis nach oben in den Bereich der Rechts/Links-Umschaltung (26) geführt ist und ein abgewinkelter Schenkel (44a) der mit dempositiven Pol verbundenen Kontaktbahn (44) unmittelbar für beide Schalter (S1, S2) Festkontakte bildet.

12. Vorrichtung nach Anspruch 11, dadurch gekennzeichnet, daß eine weitere innere, parallel zur ersten Kontaktbahn (50) für den Minusanschluß verlaufende Kontaktbahn (52) für den vom Hybridbaustein (22) gesteuerten Strom bzw. bei dessen Überbrückung für den Plusanschluß vorgesehen ist, daß beide Kontaktbahnen aus gestanzten und entsprechend abgebogenen einstückigen Blechteilen bestehen, längs der hinteren schmalen Querseite parallel zueinander angeordnet nach oben zum Rechts/Links-Umschalter laufen und sich mit einem abgewinkelten Querschenkel (50b, 52b) über die gesamte Breite des Schaltergehäuses zwischen dem Bereich der Drückerführung (25) und dem Bereich der Rechts/Links-Umschaltung (26) bis zum Durchdringungsbereich der Drückerachse (15) in das Gehäuseinnere erstrecken.

13. Vorrichtung nach Anspruch 12, dadurch gekennzeichnet, daß die parallel liegenden Kontaktbahnen nach oben in den Teilgehäuseeinsatz (57) des Rechts/Links-Umschalters geführte, abgebogene Teillappen (50c, 52c) bilden und an ihrem Endbereich mit nach unten abgebogenen kurzen Endschenkeln (50d, 52d) Festkontakte für einen vom inneren Drückerteil (33) gelagerten und geschalteten Bremsschalter (S4) bilden.

14. Vorrichtung nach einem der Ansprüche 1-13, dadurch gekennzeichnet, daß die am Durchdringungspunkt in das Gehäuse von einer Dichtung (34) umgebene Drückerachse (15) im Gehäuseinneren in die angenähert rechteckförmige Form des inneren Drückerteils (33) übergeht, welches nach unten zu den Nockenflächen (38) der Stößel (35a, 35b) die Nockenlaufbahn (39) mit Teilanschrägung bildet, in seinem mittleren Teil in einer Bohrung (41) die kräftige Vorspannungsfeder (40) aufnimmt, die sich an der von dem inneren Kontaktbahnverlauf abgedeckten schmalen Rückfläche des Gehäuses abstützt, und nach oben angrenzend zu den quer geführten Kontaktbahnschenkeln (50b, 52b) in einer Aufnahme (54) eine unter dem Druck ihrer eigenen Vorspannungsfeder (55) stehende Kontaktbrücke (53) des Kurzschlußschalters (S4) lagert, deren Kontaktenden in der freigegebenen Position (äußerer Endanschlag) des inneren Drückerteils (33) die beiden von den inneren Kontaktbahnen (50, 52) gebildeten abgebogenen Schenkel (50d, 52d) als Festkontakte miteinander verbindet.

15. Vorrichtung nach einem oder mehreren der Ansprüche 1-14, dadurch gekennzeichnet, daß die erste innere, über eine äußere Steckzunge (11b) mit einem der Anschlüsse (Minuspol) des Akkus verbundene Kontaktbahn (50) mit einem angrenzenden Kontaktschenkel (47a) eines weiteren Kontaktwinkels (47) auf dem Keramiksubstrat (22a) verbunden ist (Handlötstelle 51) und nach oben weiterführend den Minuspsolanschluß in den Bereich der Rechts/Links-Umschaltung (26) und zum Bremsschalter (S4) bringt und daß eine zweite Verbindung (Handlötstelle 53) zwischen einem weiteren Kontaktschenkel (46a) und der zweiten, an dieser Stelle beginnenden inneren Kontaktbahn (52) gebildet ist, die parallel zur ersten nach oben führt in entsprechend komplementärer Ausbildung, wobei der weitere, von dem Keramiksubstrat (22a) ausgehende Kontaktschenkel (46a) mit einer Verbreiterung gleichzeitig den zweiten Festkontakt für den By-Pass- bzw. Vollastschalter (S2) bildet, durch welchen die Elektronik im Vollastbetrieb überbrückt wird.

16. Vorrichtung nach Anspruch 14, dadurch gekennzeichnet, daß das innere Drückerteil in einer seitlichen Führung einen gabelförmigen Schleifer (28) aufnimmt, dessen Schenkel unter Vorspannung unmittelbar auf auf dem Keramiksubstrat aufgebrachte Widerstandsbahnen gleiten.

17. Vorrichtung nach einem der Ansprüche 1-16, dadurch gekennzeichnet, daß der im oberen Teil des Schaltergehäuses (21) angeordnete Rechts/Links-Umschaltbereich (26) einen inneren Wandstruktureinsatz (57) umfaßt, der mittels Ausnehmungen, Vorsprüngen, Nasen u. dgl. zunächst die beidseitigen Kontaktlappen (50c, 52c) der inneren Kontaktbahnen (50, 52) lagert sowie angrenzend zu diesen von einer Schaltwippe (20) in jeweils gegenläufigen Kontaktpositionen zu diesen gedrückte Kontaktwippen, die schwenkbar in weiteren abgewinkelten und mit Steckzungen (12a, 12b) zur Verbindung mit dem Motor nach außen geführte Kontaktbahnen (59a, 59b) aufgenommen sind.

18. Vorrichtung nach Anspruch 17, dadurch gekennzeichnet, daß der innere Gehäusestruktureinsatz (57) für die Rechts/Links-Umschaltung dort, wo von ihm ausgehende Steckzungen (12a, 12b) das Schaltergehäuse durchsetzen, mit eigenen Vorsprüngen (57a, 57b) in fensterartigen Ausnehmungen (66) des Gehäuses sitzt.

19. Vorrichtung nach einem der Ansprüche 1-18, dadurch gekennzeichnet, daß bei freigegebenem Drückergriff (14) der Druck der starken Vorspannungsfeder (40) auf das innere Drückerteil (33) beidseitig aufgefangen und von den Gehäusewandungen dadurch ferngehalten wird, daß mindestens eine der inneren Kontaktbahnen (50, 52) sowohl den hinteren Anlenkpunkt der Feder hintergreift als auch mit den vorderen Festkontakten für den Kurzschlußschalter (54) bei gegen eigenen Federdruck zurückweichender Kontaktbrücke (53) an dann frei werdenden Anlagevorsprüngen des inneren Drückerteils (33) anliegt.

20. Vorrichtung nach einem oder mehreren der Ansprüche 1-19, dadurch gekennzeichnet, daß am Gehäuse lediglich vier nach außen ragende Steckzungenanschlüsse (11a, 11b; 12a, 12b) vorgesehen sind zur zweipoligen Verbindung mit dem Akku sowie mit dem antreibenden Motor.

21. Vorrichtung nach einem der Ansprüche 1-20, dadurch gekennzeichnet, daß der oberhalb des Drückergriffs (14) angeordnete Schalthebel (16) für die Rechts/Links-Umschaltung bei gedrücktem Drückergriff gegen Verschwenkung gesichert ist und über eine Langloch/Zapfengleitverbindung an der Schaltwippe (20) des Rechts/Links-Umschalters angreift.

22. Vorrichtung nach einem der Ansprüche 1-21, dadurch gekennzeichnet, daß das Gehäuse (21) des Elektronikschalters aus einem schachtelförmigen, die Tiefe des Gehäuses vorgegebenen Grundteil besteht, in welches die einzelnen Schaltungskomponenten aufeinanderfolgend eingesetzt sind, und einem das Grundteil auf der einen Seite abdeckenden Deckel (21b).

Fig.1

Fig.2

# Fig.3

# Fig.4

EP 0 489 343 A2

# Fig.5

18
19
58a
62  61  20

63  16a
12b
29

# Fig.6

52c  50c
X  X
52
52a
53
22
47a
51
29
50
50a
11b

EP 0 489 343 A2

Fig.7

Fig.8

Fig.9

Fig.10

EP 0 489 343 A2

# Fig.11

50b

50c

50d

# Fig.12

50c

50

50a

# Fig.13

50

50c

50d

# Fig.14

52c

52a

52d

Fig.15a

48a
48b
45
46
D1
48
47a
47

49
IC
32
32a
46a

Fig.15b

29
46
46a
47a

Fig.15c

46  29
32
32a
46a

EP 0 489 343 A2

19

# Fig.16

EP 0 489 343 A2